# EUROPEAN PATENT APPLICATION

(11) **EP 3 312 693 A1**
(43) Date of publication of application: **25.04.2018**
(21) Application number: 16195049.8
(22) Date of filing: 21.10.2016
(51) Int. Cl.: G05B 19/418

(54) **METHODS & APPARATUS FOR CONTROLLING AN INDUSTRIAL PROCESS**

(71) Applicant: ASML Netherlands B.V., 5500 AH Veldhoven (NL)
(72) Inventor: KOU, Weitian, 5500 AH Veldhoven (NL); YPMA, Alexander, 5500 AH Veldhoven (NL); HAUPTMANN, Marc, 5500 AH Veldhoven (NL); KUPERS, Michiel, 5500 AH Veldhoven (NL); HAN, Min-Sub, 5500 AH Veldhoven (NL)
(74) Representative: Peters, John Antoine

(57) **Abstract**

A lithographic process is performed on a plurality of semiconductor wafers (900; 1020). The method includes selecting one or more of the wafers as sample wafers (910-914; 1030-1034). Metrology steps (922; 1042) are performed only on the selected sample wafers. Based on metrology results (924; 1046) of the selected sample product units corrections are defined for use in controlling processing of the wafers or future wafers. The selection of sample product units is based at least partly on statistical analysis of object data (902; 1006) measured in relation to the wafers. The same object data or other data can be used for grouping wafers into groups. Selecting of sample wafers can include selecting wafers (910-914; 1030-1034) that are identified by said statistical analysis as most representative of the wafers in their group. The selecting of sample wafers can include elimination of product units (916; 1036) that are identified as unrepresentative.

## Description

### BACKGROUND

### Field of the Invention

The invention relates to methods of controlling an industrial process by feedback based on performance parameters measured on processed product units. An example of an industrial process for which the method has been developed is a lithographic process, which includes one or more steps of transferring a pattern from a patterning device onto a substrate using a lithographic apparatus. The invention further relates to a control apparatus for an industrial process and to a computer program product for causing a data processing apparatus to implement the methods and apparatus described.

### Related Art

A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations before and after the step of actually exposing or otherwise patterning the substrate at a target location. Many 'fingerprints' in the performance parameters can be identified, and feedback loops implementing advanced process control can be applied to improve the overall performance of the process.

Advanced process control (APC) identifies correctable variation in a performance parameter such as overlay, and applies one set of corrections to a lot (batch) of wafers. In determining these corrections, corrections from previous lots are taken into account in order to avoid overcorrecting the noise in the measurements. For adequate smoothing of current corrections with previous ones, the history of corrections taken into account should match the context of the current lot. "Context" in this regard encompasses any parameters that identify variants arising within the same overall industrial process. The layer ID, layer type, product ID, product type, reticle ID and so forth are all context parameters that may lead to different fingerprints in the finished performance. In addition to the individual scanners that may be used in a high-volume manufacturing facility, the individual tools used for each of the coating, etching, and other steps involved in semiconductor manufacturing can also vary from lot to lot or wafer to wafer. Each of these tools can impose a particular error "fingerprint" on the products. Outside the field of semiconductor manufacturing, similar situations may arise in any industrial process.

To ensure accurate feedback control appropriate to the particular context, different lots (batches) of product units can be treated within separate "threads" in the APC algorithms. Context data can be used to assign each product unit to the correct thread. In the case of a manufacturing plant producing usually high volumes of only a few types of products by the same process steps, the number of different contexts may be relatively small, and the number of product units in each thread will be ample to allow smoothing of noise. All of the lots having a common context can be assigned to their own thread to optimize the feedback correction and the ultimate performance. In case of a foundry producing many different types of product in very small production runs, the context may change more often, and the number of lots having exactly the same context data may be quite small. Using only the context data to assign lots to different APC 'threads' may then result in a large number of threads, with a small number of lots per thread. Complexity of the feedback control increases, and the ability to improve performance for low-volume products is reduced. Combining different lots into the same threads without sufficient regard to their different contexts will cause loss of performance also.

Different wafers within a lot may in practice have different contexts, but current control systems are not adapted to use this different context to allow effective per-wafer control.

International patent application PCT/EP2016/072363 dated 21 September 2016, not published at the priority date of the present application, discloses control systems in which lots and wafers for APC or other control loops are grouped into threads by context criteria, where previously only corrections specific to each lot could be envisaged, optionally with corrections specific to each chuck (substrate support) in a dual-chuck apparatus. The relevant context parameters are identified by performing firstly a data-driven clustering using object data measured on or in relation to the product units, and then refining the clustering to identify relevant context criteria from among all available context. Such control systems are also described in the paper by H-G Lee, et al "Reduction of in-lot overlay variation with integrated metrology, and a holistic control strategy", Proc. SPIE 9635, Photomask Technology 2015, 96351S (October 23, 2015); doi:10.1117/12.2196879. By providing a structured way to identify relevant context parameters, information may become available to allow a wafer by wafer process correction to be calculated. In patent application PCT/EP2016/072363 it is also disclosed that the number of threads can effectively be reduced further by defining parameter-specific (e.g. tool-specific) fingerprints or corrections and synthesizing a thread-specific fingerprint/correction by combining the parameter-specific fingerprints/corrections of the parameters indicated in the context data for the current wafer.

A significant overhead in any advanced process control system is the number of measurements required to provide meaningful feedback and/or feedforward corrections. To reduce this metrology overhead, only a few sample points may be measured on a few sample wafers, for example using sampling scheme optimization of the type disclosed in patent application WO2015110191A1 (Wildenberg & Mos). To reduce the metrology overhead further, only a few sample wafers may be measured, typically one or two per chuck. In a multi-threaded control situation, however, the requirement becomes to measure one or more wafers per thread. Unless the measured sample wafer is perfectly typical of the wafers in the group (thread), then noise is effectively introduced into the control system.

The contents of the patent applications WO2015110191A1 and PCT/EP2016/072363, and the contents of the Lee et al reference, are incorporated herein by reference, as background to the present disclosure.

A diagnostic apparatus for root cause analysis a lithographic manufacturing facility or other industrial process is described in published patent application WO2015049087A1. The diagnostic apparatus performs multivariate analysis of object data measured on or in relation to the product units. Similar types of multivariate analysis can be used in the clustering method described above. One application of the diagnostic apparatus is to provide "excursion detection", in other words to identify "outlier" lots which should be excluded from further processing, and/or subjected to further investigation to eliminate similar lots occurring in future.

Techniques for optimizing set-up and ongoing control operations are is disclosed in another patent application EP15202675.3 dated 24 December 2015, also not published at the present priority date.

### SUMMARY OF THE INVENTION

The invention aims to enable improved monitoring and control of industrial processes, including processes where the performance of the process for different product units may be influenced by different context. The invention aims in particular to improve or maintain accuracy of control, without unduly increasing the metrology overhead. The invention in some embodiments aims to allow control in lithographic manufacturing processes, optionally multi-threaded processes.

The invention provides a method of controlling an industrial process method of controlling an industrial process performed on a plurality of product units, the method comprising:
(a) selecting one or more of the product units as sample product units;
(b) performing one or more metrology steps only on the selected sample product units out of the plurality of product units; and
(c) based at least partly on metrology results of the selected sample product units obtained in step (b), defining corrections for use in controlling processing of the plurality of product units and/or similar product units,
wherein the method further comprises receiving object data representing one or more parameters measured in relation to the plurality of product units and wherein in step (a) the selection of sample product units is based at least partly on statistical analysis of the object data.

The product units may be for example wafers in a semiconductor manufacturing facility. By use of statistical analysis to select product units that are representative of the plurality of wafers, the metrology results can give more reliable performance improvement. The product units may be grouped and sample wafers selected per group.

The invention further provides a control apparatus for an industrial process the control apparatus comprising:
an arrangement for selecting one or more of the product units as sample product units for metrology; and
an arrangement for using metrology results of the selected sample product units to define corrections for use in controlling processing of the plurality of product units and/or similar product units,
wherein the selecting arrangement is arranged to for receiving object data representing one or more parameters measured in relation to the plurality of product units and to select the sample product units is based at least partly on statistical analysis of the object data.

The invention further provides a computer program product comprising machine readable instructions for causing a general purpose data processing apparatus to implement all or part of a method and control apparatus as set forth above. The machine readable instructions may be embodied in a non-transitory storage medium.

Further features and advantages of the invention, as well as the structure and operation of various embodiments of the present invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying schematic drawings in which:
Figure 1 depicts a lithographic apparatus according to an embodiment of the invention;
Figure 2 shows schematically the use of the lithographic apparatus of Figure 1 together with other apparatuses forming a manufacturing facility for semiconductor devices, the facility including a control apparatus according to embodiments of the present invention;
Figure 3 illustrates schematically two known feedback control methods applied in a manufacturing facility of the type shown in Figure 2;
Figure 4 illustrates schematically the operation of a feedback control method in accordance with one embodiment of the present disclosure;
Figure 5 and Figure 6 illustrate different examples of automatic clustering of object data, illustrating selection of representative wafers in principle in accordance with principles of the present disclosure;
Figure 7 is a flowchart of a method according to principles of the present disclosure;
Figure 8 is a more detailed flowchart of a method in accordance with an embodiment of the present disclosure;
Figure 9 illustrates the application of the method of Figure 8 to the selection of send-ahead wafers and excursion wafers in one example of a manufacturing method embodying the principles of the present disclosure;
Figure 10 illustrates the application of the method of Figure 8 in another example of a manufacturing method embodying the principles of the present invention;
Figure 11 illustrates schematically a further control method that may be applied in a manufacturing facility of the type shown in Figure 2;
Figure 12 is a flowchart of an alternative method according to principles of the present disclosure, suitable for application in the control apparatus of Figure 11; and
Figure 13 illustrates schematically data processing hardware programmable to implement the methods and apparatuses of the embodiments of the invention.

### DETAILED DESCRIPTION OF EXEMPLARY EMBODIMENTS

Before describing embodiments of the invention in detail, it is instructive to present an example environment in which embodiments of the present invention may be implemented.

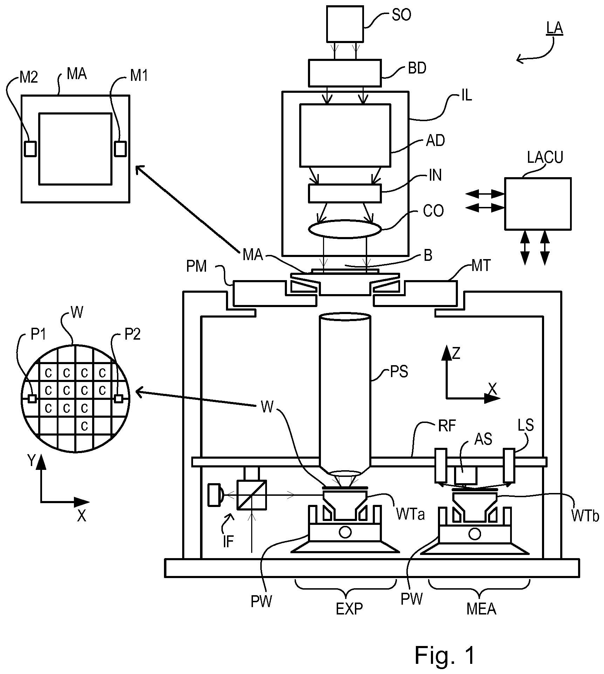

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination there-of, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the litho-graphic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device sup-port MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning de-vice (e.g., mask) MA, the mask alignment marks may be located between the dies. Small alignment mark may also be included within dies, in amongst the device features, in which case it is desirable that the marks be as small as possible and not require any different imaging or process conditions than adjacent features. The alignment system, which detects the alignment marks is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "mask-less" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment marks on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The apparatus further includes a lithographic apparatus control unit LACU which controls all the movements and measurements of the various actuators and sensors described. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems.

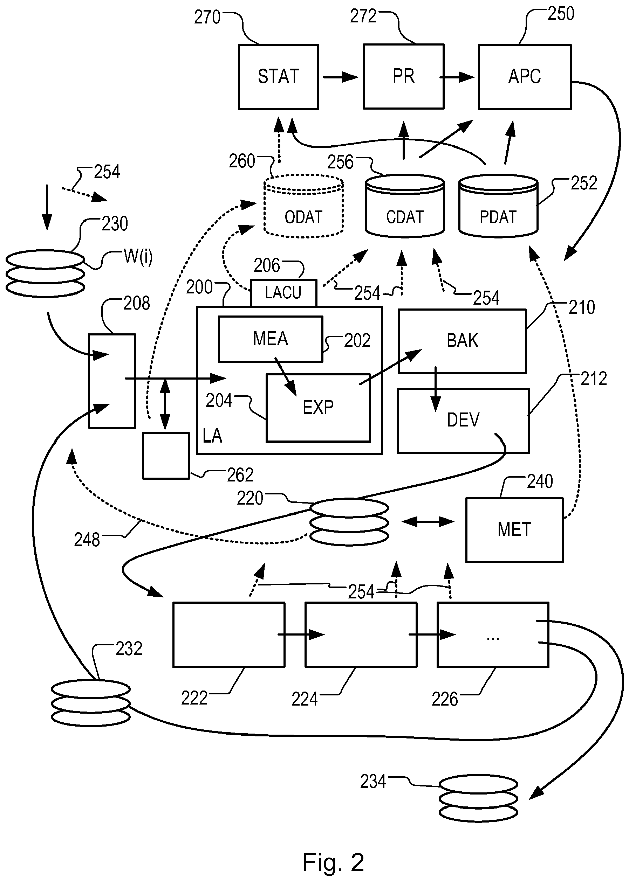

Figure 2 at 200 shows the lithographic apparatus LA in the context of an industrial manufacturing facility for semiconductor products. Within the lithographic apparatus (or "litho tool" 200 for short), the measurement station MEA is shown at 202 and the exposure station EXP is shown at 204. The control unit LACU is shown at 206. Within the manufacturing facility, apparatus 200 forms part of a "litho cell" or "litho cluster" that contains also a coating apparatus 208 for applying photosensitive resist and other coatings to substrate W for patterning by the apparatus 200. At the output side of apparatus 200, a baking apparatus 210 and developing apparatus 212 are provided for developing the exposed pattern into a physical resist pattern.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

Also shown in Figure 2 is a metrology apparatus 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. As is also well known, the metrology results from the apparatus 240 can be used to maintain accurate performance of the patterning operations in the litho cluster, by making small adjustments over time, thereby minimizing the risk of products being made out-of-specification, and requiring re-work. Of course, metrology apparatus 240 and/or other metrology apparatuses (not shown) can be applied to measure properties of the processed substrates 232, 234, and incoming substrates 230.

Another particular application of metrology apparatus 240 is the processing of so-called "send-ahead" wafers. These are effectively sample product units from a lot or batch that is about to be processed. They are sent ahead through the process, and actual performance of the process is measured on these sample product units, before the whole lot is processed. In this way, customized corrections can be calculated and applied in the processing of the current lot. Normally, the send-ahead wafers will be stripped and returned to the lot for processing with the corrections. This reworking of the send-ahead wafers is indicated schematically by path 248 in Figure 2.

To improve performance of the manufacturing process in parameters such as overlay, and CD, an advanced process control (APC) system 250 is provided. APC system 250 implements a form of feedback control based on historic performance data PDAT, which may include for example measurements of overlay and/or CD made by metrology apparatus 240, and on context data CDAT associated with individual substrates. APC system 250 therefore has access to historic performance data PDAT and which is stored in storage 252. The context data CDAT may also be regarded as "history" data, as it is data not obtained from the products themselves but representing all or part of the processing history of individual product units (wafers or other substrates), or batches of product units. Arrows 254 throughout the diagram illustrate how context data may come from any of the apparatuses. Context data may also arrive with the new substrates 230. For example, the context data may record what types of process steps have been applied, which individual apparatuses have been used in the performance of those steps, and what parameters were applied by those apparatuses (for example settings of temperature or pressure case while in etching apparatus 222, or parameters such as illumination modes, alignment recipes, etc. in the litho tool 200). The context data is stored in storage 256 for use by the APC system 252.

The performance data PDAT may be regarded as an example of object data used in some embodiments of the techniques disclosed herein. Other examples of object data may be collected and stored for used in other embodiments, and some embodiments may use different kinds of object data together, including performance data. While the performance data is derived from measurements made (directly or indirectly) on the product units that have previously gone through the processing steps being controlled, other object data ODAT may be collected in advance of or during performance of the processing. Figure 2 shows this other object data optionally collected and stored in a database 260. Such other object data may be data measured on the product units themselves, or measured on other parts involved in the industrial process. As one example, the object data stored in a database 260 may comprise the alignment data conventionally obtained by the lithographic apparatus 200 using the alignment sensors AS in the measurement station 202. As this data representing detailed measurements of positions of marks in the X-Y plane of the substrate is obtained inherently as part of the normal patterning operation, little or no penalty is incurred by instructing the control unit 206 to store the data in the object data storage 260. Alternatively or in addition to the alignment data, the object data may include height data obtained using level sensor LS, "wafer quality" signals from the alignment sensors AS and the like. In other embodiments, the object data may include data measured elsewhere in the system, and not on the product units themselves. An example of such object data might be mask (reticle) alignment data obtained using the mask alignment marks M1, M2 and sensors in the substrate supports of the lithographic apparatus of Figure 1.

Another particular example of object data may be analyzed, wafer shape data can be measured by a further metrology apparatus 262. The apparatus may be for example a patterned wafer geometry scanner of the type available from different manufacturers. In some production environments, such a tool is used to measure out-of-plane distortion (topography) across every wafer, caused by process-induced stresses. The lithographic apparatus control system can calculate corrections for in-plane distortions (overlay error) that would otherwise be introduced when the distorted wafer is clamped flat onto the substrate table.

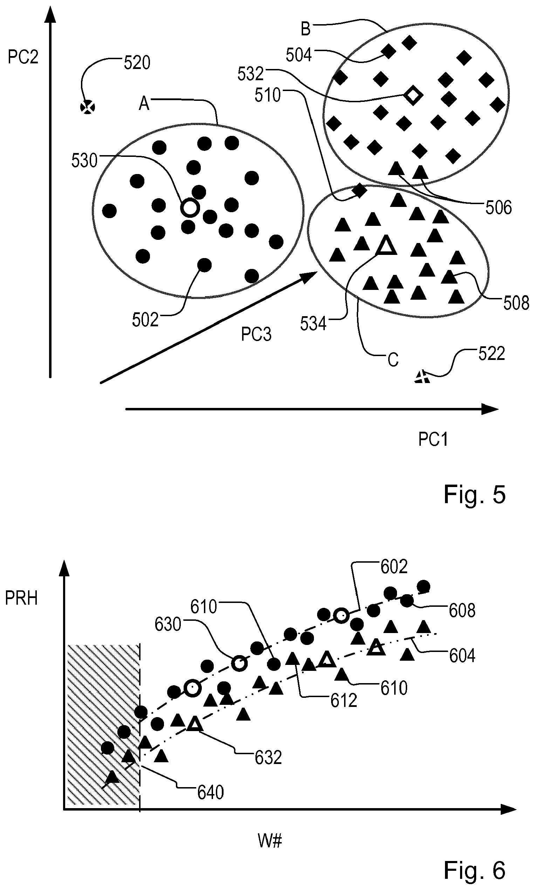

In summary, the term "object data" as used in the introduction and claims encompasses a wide variety of data that may be gathered in the manufacturing facility, either for historic product units, or new product units to be processed. In particular, the term "object data" as used in the introduction and claims encompasses both the performance data PDAT (measured from processed product units after processing and stored in storage 252) and the other types of object data ODAT (measured from product units or other systems before and/or during processing and stored in storage 260). Examples using both types of object data will be described below with reference to Figures 5 and 6.

While Figure 2 shows separate storage 252, 256, 260 for each of the context data, performance data and object data, it will be appreciated that these different types of data may be stored in one common storage unit, or may be distributed over a larger number of storage units, from which particular items of data can be retrieved when required. Further, whilst the context data 254 is shown as emanating from each individual apparatus 222, 224, etc. the data may be collected through a central control system that controls the operation of the lithocell and/or the manufacturing plant as a whole.

Each record in the context data and performance data storage is labeled with a unique identifier. Noting that an individual wafer might pass repeatedly through the same litho tool in the course of a manufacturing process, or might pass through different tools all measuring the same marks, it is possible collect data for the same product unit at different stages of the manufacturing process. Each of these instances of measurement can be treated in the analysis as an independent product unit. In the case where there are multiple instances of the same wafer being measured at different stages in a complex manufacturing process, however, the object data will include an identifier that uniquely identifies not only the individual wafer, but the stage of processing in which it has been measured. Typically in a lithographic process, different instances of the same substrate will be associated with patterning successive layers of a device structure.

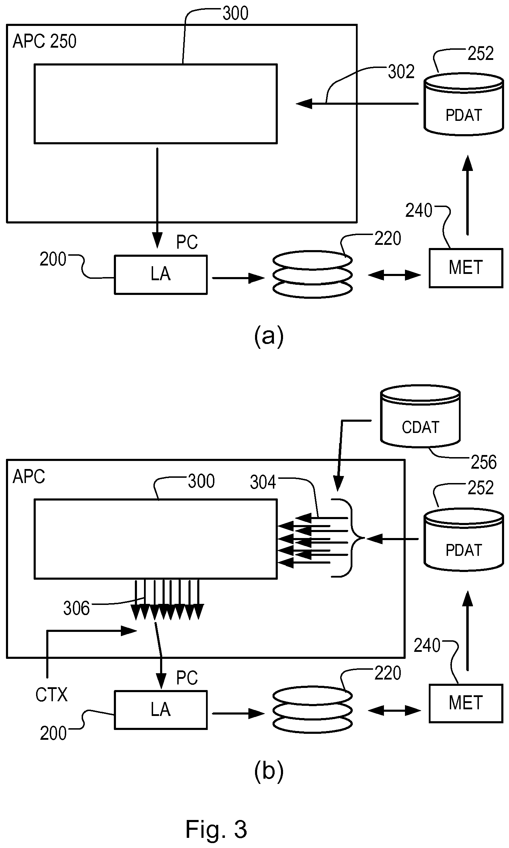

Figure 3 (a) illustrates schematically the operation of one type of control method implemented by APC system 250. Historic performance data PDAT is received from the storage 252, having been obtained by metrology apparatus 240 or other means from wafers 220 that have been processed by lithographic apparatus 200 and associated apparatuses of the lithocell. A feedback controller 300 analyzes the performance parameters represented in the performance data for recent lots, and calculates process corrections PC which are fed to the lithographic apparatus 200. These process corrections are added to the wafer-specific corrections derived from the alignment sensors and other sensors of the lithographic apparatus, to obtain a combined correction for the processing of each new lot.

To reduce the metrology overhead in providing such control method, it may be that not all of the wafers are measured, or fully measured, using the metrology apparatus 240. Techniques disclosed below can be used to improve the selection of sample wafers for metrology.

Figure 3 (b) illustrates schematically the operation of another type of control method implemented by a known APC system 250. As can be seen, the general form of the feedback control method is the same as that shown in Figure 3 (a), but in this example, context data relating to the historic wafers and context data CTX relating to the current wafer is used to provide a more selective use of the performance data PDAT. Specifically, while in the earlier example the performance data for all historic wafers was combined in a single stream 302, and the modified method, context data from storage 256 is used to assign the performance data for each historic lot to one of several threads 304. These threads are processed effectively in parallel feedback loops by feedback controller 300, yielding multiple process corrections 306, each based on the historic performance data of wafers in one of the threads 304. Then, when new lots are received for processing, their individual context data CTX can be used to select which of the threads provides the appropriate context data 306 for the current wafer. Context data for this purpose might include wafer shape data measured on the wafers prior to loading into the lithographic apparatus.

In general, it will be seen that the operator of the manufacturing facility has to make decisions as to the granularity of the feedback control. In the example of Figure 3 (a), no granularity is applied, and all product units processed as a single thread. In cases where it is known that the individual wafer table or "chuck" has a strong influence on the performance, then corrections per lot and per chuck are known to be applied. In the example of Figure 3 (b), then differing degrees of granularity may be provided, but always dependent on the suitable performance data and context criteria being known. In known practice, corrections will not normally be provided per individual wafer, but rather per lot. In many cases, it will simply not be known in advance, which parameters of the context data relevant for defining optimum partitioning into threads, and which are not. Accordingly, the lots may be partitioned into smaller threads than necessary, or grouped into larger threads when in fact a further partitioning would yield better performance. The patent application PCT/EP2016/072363, mentioned above describes modified control system which may be used in combination with the present disclosure. Brief details of such a control system will be repeated herein, while the full content of the patent application are incorporated herein by reference. The Lee et al reference provides further discussion of such a system.

Referring again to Figure 2, a control system is disclosed as an example in which the techniques of the present disclosure may be employed. In this modified control system, historic object data, for example historic performance data, is assigned to threads based on context data, but based on a combination of statistical analysis of the historic object data and context information. A statistical analysis module 270 is provided which receives primarily the historic performance data PDAT from storage 252 and performs a data-driven partitioning of the historic product units. In a partition refining module 272, historic context data CDAT from storage 256 is used to refine the partitioning with reference to the context. In this way, relevant context data can be used to assign performance data into an appropriate thread, without unnecessarily proliferating the number of threads by reference to context data that is not in fact so relevant. One benefit of such a step is that production units whose context would place them in a very underpopulated thread with poor feedback performance as a result, can be assigned to a better populated thread that still provides effective performance improvement. While examples will firstly be described using performance data from storage 252, it has already been mentioned that in other examples other types of object data ODAT from storage 260 may be used, either instead of or in addition to performance data. Accordingly, unless the context requires otherwise, references to performance data in the present description should be understood as references to object data more generally.

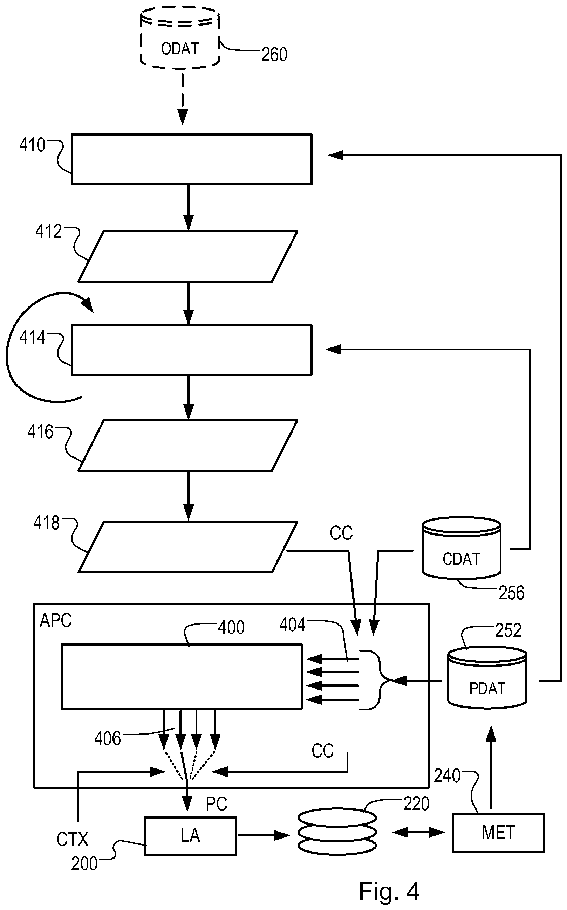

Figure 4 is a flowchart of the method implemented by the statistical analysis module 270 and partition refining module 272 in one embodiment of the control method illustrated in Figure 2. A feedback controller 400 is shown at the bottom of the picture, which functions in a way very similar to the feedback controller 300 of Figure 3 (b). Historic performance data PDAT from storage 252 is assigned to different threads 404, in accordance with context data CDAT from storage 256. Feedback controller 400 produces process corrections (PC) 406 for multiple threads 404, and chooses the appropriate process correction PC for a current wafer, using the current wafer context data CTX. Unlike the known method, however, the historic performance data is assigned to threads 404 not purely by reference to the historic context data, but are assigned also in light of context criteria CC that have been derived by a method that will now be described. These same context criteria are used in combination with the current wafer context data CTX, when choosing the process corrections to be applied on future wafers. Where the control systems allow it, process corrections can be chosen and applied on a per-wafer basis, or they may be applied per lot if preferred. Some types of performance data may only be available on a per-lot basis, because, frequently, detailed performance measurements are not made on every wafer. However, over many lots, wafers can be sampled in such a way as to discriminate statistically between different contexts on a per-wafer basis. Further below, we describe techniques to improve the sampling of wafers for this purpose.

At step 410, a statistical analysis of the historic performance data PDAT is performed, without reference to the context data associated with the product units (wafers) on which performance parameters of the industrial process have been measured. Different forms of statistical analysis can be envisaged, and only a couple of examples will be mentioned for illustration here. In one example, step 410 comprises performing a multivariate analysis, for example principal component analysis (PCA), to identify a number of components contributing to performance parameters measured from the product units themselves (wafers in this case). Different forms of multivariate analysis may be used, and PCA analysis is referred to herein purely as one example. In the specific example case of PCA, the identified component vectors are orthogonal in the multidimensional space. In another method, called Independent Component Analysis (ICA), the component vectors are independent (meaning that none of them can be written as a linear combination of the others). The ICA technique leaves all second and higher order cross-correlations at zero, while the orthogonality of the PCA technique forces second order cross-correlations to be zero but may leave non-zero higher order cross-correlations. Step 410 and the analysis performed will be referred to hereinafter as the PCA analysis for convenience, without intending any limitation.

A detailed implementation of such statistical analysis in a lithographic manufacturing facility or other industrial process is described in published patent application WO2015049087A1. The contents of that application are hereby incorporated by reference. In the published patent application, statistical analysis such as PCA or another multivariate analysis is used to extract diagnostic information from object data, which may be performance data measured from product units after processing, and/or may include other object data, such as positional deviations measured using the alignment sensor (AS, Figure 1) prior to patterning. In the method now described, the purpose may be different, but the principles of the analysis and the form of the results can be similar to those in the prior published patent application. The diagnostic methods of the prior patent application can be implemented of course in the manufacturing facility at the same time as the control methods of the present application.

At step 412, the results of the statistical analysis are applied to define a first partitioning of the product units represented in the historic performance data. This partitioning is based on the position of each product unit in a multidimensional space defined by the principal component vectors, within the multidimensional space defined by the set of performance parameters measured and represented in the performance data PDAT. By "partitioning" we mean assignment of membership of each of the set of product units between two or more subsets. In a "hard" partitioning, each product unit is either a member of a certain subset or it isn't. A "soft" partitioning may also be used, in which a product unit is assigned membership values indicating degrees of membership, or probabilities of membership of more than one subset. The skilled reader will be able to adapt the present teaching to allow for soft partitioning. For simplicity of the present description, only hard partitioning will be illustrated.

Figure 5 illustrates figuratively the partitioning of product units into different subsets or "clusters", based on the results of the statistical analysis. Performance data for a number of product units is represented by points on a three-dimensional graph, whose axes are principal components PC1, PC2 and PC3 found by the statistical analysis. The product units in this example have been assigned to three clusters, labeled A, B and C. Thus, product unit represented by point 502 is initially assigned to cluster A, product units represented by points 504 and 506 are initially assigned to cluster B, and points 508 and 510 are initially assigned to cluster C. It should be borne in mind that this two-dimensional representation of a three-dimensional graph is only a simplified illustration, and partitioning may be performed based on three, four, 10 or more components.

Considering now the different context that applies to different product units within the population of product units represented in the historic performance data, the different shapes of the data points in Figure 5 (diamond, circle, triangle) are used to indicate three different sub-populations, defined by their processing history, which can be represented in context data. It may be assumed that different principal components represent error fingerprints caused by certain features or combinations of features in the processing context of each product unit. Consequently, it will be seen that the partitioning into clusters A, B and C has successfully grouped the majority of product units together with other members of the same sub-population (same shape of data point). When processing future units, only the context data will be available as a basis for controlling the processing. Therefore in the method disclosed in the patent application PCT/EP2016/072363, mentioned above, further steps are taken to identify from the statistical analysis and the historic context data, what are the relevant context parameters, out of all the context parameters applying to each product unit, for the purpose of controlling for future units.

Statistical analysis step 410 and the initial partitioning step 412 are performed deliberately without reference to the context data. Therefore it may be expected that some members of a sub-population (for example statistical outliers) may be assigned initially to the "wrong" cluster. Examples of this can be seen in the diamond shaped data point 510 which has been grouped into cluster C, where the majority of data points are triangle shaped and so have a different context. Similarly, a couple of triangle shaped data points 506 have been grouped in cluster B, where the majority of points have diamond shape. Accordingly, if the statistical analysis of the historic performance data would be used as the only basis for partitioning product units into threads for the purposes of feedback control, the resulting process corrections for a given thread might contain undesirable contributions from product units having a context different to others in the thread.

Also shown in Figure 5 are two "outlier" or "excursion" wafers 520, 522 that are not readily assigned to any of the clusters. These can be identified by statistical analysis, as will be described further below. Within each cluster, another sample is highlighted (530, 532, 534), which will be explained further below.

Figure 6 illustrates another example of the type of statistical analysis that might be applied, in particular a mixed regression analysis. In the example of Figure 6, the horizontal axis represents wafer number within a lot, passing through the lithographic apparatus 200. A lot may for example include 25 wafers in a typical semiconductor manufacturing facility. It is known that certain error fingerprints arise from thermal effects that build during exposure of a lot, and dissipate again prior to exposure of the next lot. An example of such an effect may be reticle (mask) heating, and a feedforward control system may define reticle heating corrections to be applied with a logarithmically increasing intensity through the course of the lot. In order to determine the appropriate logarithmic curve and intensity levels, statistical analysis of historic object data will generally be performed, rather than attempting to predict the required correction from any "first principles" calculation. As mentioned above, the object data in such an example may be other than performance data measured on processed product units. It may be object data measured before or during processing on the product units, or on other parts of the system. An example of object data is alignment data measured from each wafer. Another example is mask alignment data measured using marks on the patterning device (mask or reticle) and sensors located beside the wafer on the substrate table or associated measurement table. Mask alignment data may be particularly useful in the example of identifying reticle heating fingerprints, illustrated in Figure 6.

Analyzing the object data in terms of a reticle heating fingerprint PRH, data points from one or more lots may be plotted on a graph against wafer number, in the manner shown in Figure 6. A regression analysis can be used to fit a logarithmic curve to the observed data in a well-known manner. From experience, however, it may be known that one or more context variables may also be at play, and no single logarithmic curve can be fitted to the data set. For such a case, it is possible to apply a mixture model. Mixture models can be based on regression, PCA, ICA and/or any other statistical model. As an example, a historic population of product units may have been processed on a mixture of tools, and each tool's performance may have drifted in a particular way over time. Provided the statistical database is sufficiently extensive, a mixture model can identify and separate these different contexts without prior knowledge.

Returning to Figure 6, a mixed regression analysis, for example, will allow two, three more individual curves to be fitted, each associated with one sub-population in the data. The number of populations within the database may or may not be known or guessed in advance. In the example of Figure 6, we suppose it is known that two curves 602 and 604 should be fitted. One reason for this might be that a lithographic apparatus such as the one illustrated in Figure 1 has two chucks (substrate tables WTa and WTb), and the reticle heating errors observed appear different, depending on which wafer table is being used, because the sensors in two chucks have slightly different responses. Accordingly, the population of data points illustrated in Figure 6 may in fact derive from two sub-populations of product units, which are illustrated in the drawing by circle data points 608, 610 etc. and triangle data points 612, 614 etc.. The statistical analysis step 410, with no knowledge of the different context of these points may for example decide that a given data point belongs to the sub-population on which the second logarithmic curve 604 is to be fitted, while knowledge of the context of these product units might indicate that it belongs generally to the sub-population more relevant for the first logarithmic curve 602. Within each sub-population, a few particular samples are highlighted (630, 632), which will be explained further below.

A reticle heating correction based on such regression analysis may be something that is applied as part of a feedforward control system within the lithographic apparatus, rather than being part of the advanced process control system 250. However, the problem remains that, for new product units, it is only the context that is known. Without prior knowledge of the significance of a particular context parameter (e.g. chuck ID), how is the control system to know which are the relevant context parameters for providing a feedforward control optimized for different contexts? If there are two populations found by the mixture model, are they caused by different chuck IDs or some other factor? Even if they are caused by two different chuck IDs, is it the chuck of the present apparatus or that of a tool previously used that is causing the difference, or a combination of both?

Another example of feedforward control is the alignment process, already described in relation to the operation of the lithographic apparatus of Figure 1. Alignment data measured per wafer is fitted with an alignment model that is used to generate corrections to be applied during patterning (exposure). Applying the principles of the disclosed in the patent application PCT/EP2016/072363, mentioned above, it might be beneficial for alignment data measured for a new wafer to be used in a manner dependent on context data received with the new wafer. One way would be to vary the alignment model (potentially choosing between different alignment models) based on the context data. Analysis of historical alignment data with context data may identify which context parameters are relevant for choosing the most appropriate alignment model, per lot or even per wafer.

It should be noted that the object data used as input for the feedback control need not comprise individual measurements of position, overlay or some other parameter at points across the substrate. In one embodiment related to advanced process control of the type illustrated above, the existing APC feedback controller 300 is designed to work with performance data expressed through a parameterized model, for example expressing error fingerprints through coefficients of polynomial equations. Measurements taken from each wafer or group of wafers are considered together, and a model is fitted. In the modified feedback controller 400, the same parameterized model can be used, and the performance data for start wafers can be expressed in terms of that model. Similarly, in the example of alignment data, the object data used may be parameters of a fitted alignment model, or residuals of a fitted model, rather than raw position data.

If the model has, for example, 10 parameters, then the performance data for each wafer or group of wafers becomes represented by a set of 10 values for those parameters, and the wafer or group of wafers can be represented by a point in a 10-dimensional parameter space. The same parameters can be used to express the corrections PC, and the lithographic apparatus can be designed to respond to these parameters, either directly or by translating them into another model space. The skilled person will appreciate that this is only one example of an indirect representation of performance data. It will be appreciated that, if 100 individual overlay measurements may be taken across each substrate, then to reduce these measurements to a 10-parameter model represents a substantial benefit in the compression of data. In general, there is little benefit in analyzing errors in a form that cannot be related directly or indirectly to the parameters of the corrections available in the control system of the lithographic apparatus or other industrial process. Of course, in other embodiments, different models may be defined, but the same principles may be applied.

Returning to Figure 4, in step 414 context data CDAT from storage 256 is used in the disclosed method to refine the partitioning of the historic product units and their performance data, and in particular to impose a "logical" partitioning that is based on the statistical analysis, but makes sense when viewed in terms of the context data. Examples of this refinement step are described in more detail in the patent application PCT/EP2016/072363, mentioned above.

At 416, the refinement of partitioning is concluded and a final partitioning is defined. At 418, a set of context criteria CC is delivered, by which the product units represented in the historic performance data and new product units can be assigned unambiguously to one of a number of subsets, corresponding to respective threads 404 and 406 of the feedback controller 400. The number of threads can be far fewer than if all parameters of the context data were to be used to define unique thread for every context. Using the statistical analysis, only those context parameters that are in fact associated with differences in performance need be used as a basis for partitioning the population of historic and future product units into threads. Optional techniques for further reducing the number of threads are described in more detail in the patent application PCT/EP2016/072363, mentioned above.

The steps 410 to 418, along with the feedback controller 400 itself, can be implemented by a combination of computer hardware and software, connected to receive data from the manufacturing facility of Figure 2. The computer hardware can be located in the same facility as the litho tool and other apparatus, or it can be located remotely and connected by telecommunications channels and/or removable storage.

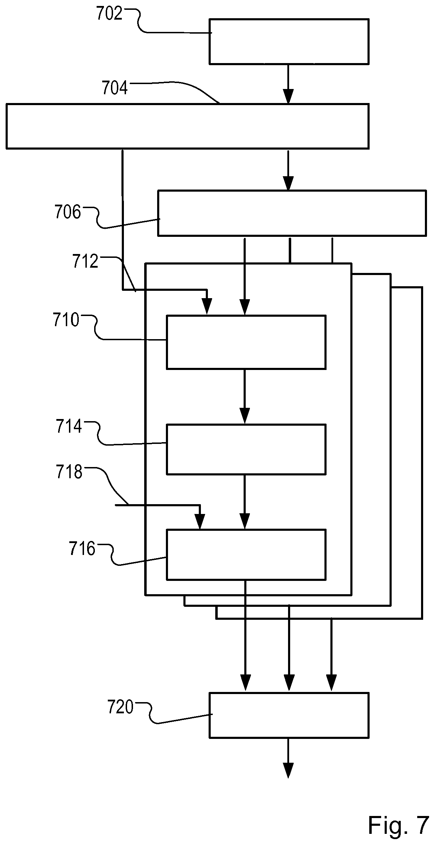

Figure 7 illustrates the general sequence of steps in a control method according to one embodiment of the present disclosure. At step 702, a set of product units, for example semiconductor wafers, are received for processing by an industrial process. At 704, object data is measured on or in relation to the set of product units (or received from a pre-existing measurement). This object data may be any of the kinds of object data referred to in the background discussion above. In the manufacturing facility of Figure 2, for example, object data may be alignment data measured within lithographic apparatus 200 as a preliminary step in patterning the wafers, it may be wafer shape data measured in the wafer shape metrology tool 262 prior to patterning the wafers, and/or it may be performance data measured using metrology apparatus 240 after a previous step where a layer has been processed. The object data may be more than one kind. Example applications illustrating some of these possibilities will be presented below.

At step 706, in this example, the set of product units being subjected to the industrial process is partitioned into a plurality of subsets. This partitioning may be performed based on context data received with the product units. Alternatively or in addition, the partitioning may be based on statistical analysis of one or more kinds of object data measured in step 704, using the methods described above with reference to Figures 4 to 6.

Then, for each subset, at 710 one or more sample product units is selected for metrology. This step is performed using object data 712 representing one or more parameters measured in relation to the plurality of product units. The selection of sample product units is based at least partly on statistical analysis of the object data 712. The object data 712 used for this step may be the same kind or a different kind than the object data (if any) used in the partitioning step 706.

At 714, one or more metrology steps are performed only on the selected sample product units out of the plurality of product units. At 716, based at least partly on the metrology of the selected sample product units, corrections are derived for use in controlling processing of the plurality of product units. The corrections may be derived using context data 718, in addition. The corrections are used at 720 to control the processing of the product units, for example to apply patterns to wafers in a semiconductor manufacturing facility.

The manner of measuring the sample product units and the manner of calculating corrections using the measurements may be any of the techniques known in the relevant manufacturing art. In accordance with the principles of the present disclosure, because the selection of sample product units is based at least partly on statistical analysis of the object data, the accuracy of control achievable can be improved, for a given level of metrology overhead.

In traditional approaches for lot-level and chuck-level control in semiconductor manufacturing, a limited set of metrology wafers (typically 2 per chuck) is selected. It is known to select wafers from the center of the lot to avoid heating effects entering the control loop. However, due to the complex processing context a lot experiences in its lifetime, the wafers inside the lot could have different overlay fingerprints, according to in which chambers or tools they e.g. have been processed, their orientation in those chambers, etc.. Typically this results in a distribution of fingerprints, often leading to "subpopulations" or groupings within the lot of wafers with similar shapes and fingerprints due to similar processing history. This distribution of fingerprints is obviously not taken into account when "randomly" picking sample wafers from a lot, and consequently these sample wafers might not be representative for the lot and the distribution of fingerprints within that lot, which may result in an overlay penalty when process corrections are based on the selected wafers and applied to the whole lot. Furthermore, there is a risk in situations where processing errors or other situations affect certain wafers, and these "excursion" wafers are selected by chance as metrology wafers. Measurements from the excursion wafers subsequently "contaminate" the overlay control loop with their excursion fingerprints. Because of the need to limit metrology overhead in high volume manufacturing situations, the number of sample wafers will be relatively small, and such contamination can have a disproportionate effect.

Where the set of wafers can be partitioned into subsets, as illustrated in Figure 7, a first improvement in the selection of sample wafers can be made by selecting sample wafers specifically within each subset. In the multi-threaded control method of Figure 4, then, the measured performance data can be applied in controlling the appropriate thread. Nevertheless, the multi-threaded method makes the problem of metrology overhead more acute, and random selection of sample wafers within the subsets may still lead to metrology being performed on a wafer that is not truly representative of the majority.

In accordance with the principles of the present disclosure, the selection of sample product units in the method of Figure 7 is performed with the aid of statistical analysis of object data, so that the selected of unrepresentative product units is avoided or reduced.

To consider this, refer again to the examples of Figures 5 and 6. Three subsets or "clusters" of wafers have been identified, which broadly fall in three distinct regions of the multi-dimensional space defined by principal components PC1, PC2, PC3. Using the principle components as a reference, excursion wafers 520 and 522 can be recognized. In some embodiments of the method of Figure 7, the statistical analysis of object data 712 allows these excursion wafers to be identified and excluded from consideration as potential sample wafers for metrology in step 710. In such embodiments, therefore, selecting the sample product unit or product units includes elimination of product units that are identified by said statistical analysis as unrepresentative of the plurality of product units. Even if sample wafers would then be selected at random from the remaining members of each subset, at least the problem of "contamination" mentioned above, would be reduced.

Boundaries for the exclusion of excursion wafers can be defined in the multi-dimensional space, or in a single dimension, if desired. The boundaries can be defined entirely automatically and/or with expert assistance, and may have arbitrary shape in the multi-dimensional space defined by the statistical analysis. For example, tight boundaries may surround individual clusters, or one boundary may encompass the entire set. The boundaries can be refined as volume manufacturing progresses, and may be set wider in a development phase.

To further improve the quality of monitoring and performance control, in some embodiments of the method, selecting sample product units for metrology includes preferentially selecting product units that are identified by said statistical analysis as most representative of the plurality of product units. In the example of Figure 5, certain wafers 530, 532 and 534 are highlighted which are deemed to be most representative of their particular cluster. Using one or more of the observed fingerprints, the wafers of the cluster A can be analyzed to identify wafer 530 as having the combination of fingerprint coefficients most typical of the wafers in the cluster. In the drawing, this is illustrated by wafer 530 being closest to the center of the distribution of wafers of the cluster, within the multidimensional space. Similarly, each wafer 532, 534 is centrally located in the distribution of wafers in the clusters B and C, respectively.

In terms of a practical implementation, various statistical measures can be applied to identify a desired number of most representative product units. In general, the most representative wafers for each cluster and chuck are selected, based on their position within their cluster and/or with respect to the neighboring clusters. One way to achieve this is by calculating a key performance indicator (KPI) or score value per wafer, using some to a defined algorithm. One example KPI that can be used for this is the "silhouette" value, described by Peter J. Rousseeuw, in "Silhouettes: a Graphical Aid to the Interpretation and Validation of Cluster Analysis", Computational and Applied Mathematics 20: 53-65, 1987. Selecting the wafer or wafers having the highest silhouette value(s) is one way to achieve the selection of representative wafers to serve as the sample wafers for metrology. From the same calculation, low silhouette values could additionally be used identify excursion wafers. Further constraints can be applied if desired, for example to avoid selecting excursion wafers. Another example of a constraint would be to avoid selecting the first few wafers in a lot, whose processing may be untypical because of thermal effects. As mentioned, different sample wafers can be selected for calculating corrections for each different subset. The metrology wafer selection mechanism can be refined in a "run-to-run" control system, which determines in an adaptive manner how feedback control should be implemented in the APC system. Selection and optimization of such control strategies is the subject of the patent application EP15202675.3, mentioned above.

In the example of Figure 6, where wafers are clustered along two curves 602, 604 by a mixed regression analysis, ers 630, 632 that lie on or close to the curve can be selected as representative samples for metrology, in preference to other wafers that belong to the relevant cluster, but are some distance from the curve in the parameter PRH that is plotted. The distance from the curve may be used as a score for ranking the wafers in this selection process. KPIs such as Silhouette value can be extended to clustering in a curve-based space, as well as clustering in the principle components.

As in the case of Figure 5, additional constraints may be designed into the selection of sample product units. Such a constraint is illustrated at 640 in Figure 6, which forbids the selection of a sample wafer from among the first number of wafers in the lot. In other words, it is deemed that the earliest wafers in the lot are not to be considered as representative of the majority of the wafers, even if they would fall exactly on the curve 602 or 604.

It is a matter of design choice whether the partitioning of the set of product units into subsets in step 706 is the same or different than object data used in step 710 for selecting the sample product units. Different scenarios will be illustrated below.

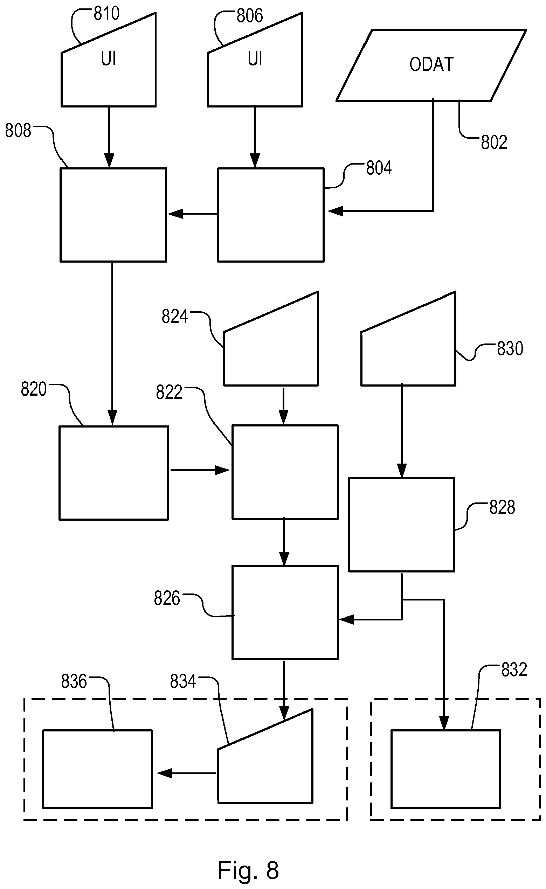

Figure 8 is a more detailed flowchart of a control method including clustering (partitioning) and sample selection in an embodiment of the method of Figure 7. Clustering and sample selection can be executed on many different types of object data, as long as it is representative for the distribution of overlay fingerprints inside the lot. These input data could originate from offline wafer shape measurements such as provided by the wafer shape metrology apparatus 262, or alignment data obtained automatically during patterning operations in the lithographic apparatus 200. The object data is received at 802 subsequently preprocessed at 804. The preprocessing step 804 may for example remove outliers from the object data (measurements that are suspected to be faulty). The preprocessing step may also remove non-desired systematic fingerprints, such as content that can be captured by the active alignment strategy. The preprocessing step may also eliminate chuck-to-chuck offsets that might dominate a subsequent partitioning step. User input 806 can be used to configure the preprocessing step.

In a step 808, the object data is decomposed in order to yield a set of coefficients (for example principal components PC1, PC2 etc.) that can be considered as reference fingerprints. For each wafer, a specific set of coefficients (weights), when used to combine these reference fingerprints, will yield (approximately) the fingerprint of the individual wafer. This decomposition can be achieved for example by means of Principal Component Analysis (mentioned above) or Zernike decomposition. Alternatively, the reference fingerprints have already been obtained by statistical analysis of object data from wafers processed during obtained during a setup phase. In that case, the coefficients for new wafers obtained via projection of the wafer onto the stored reference fingerprints. Again, the detailed implementation of the step 808 can be controlled by user input 810.

The method of Figure 8 then moves into a clustering and sample selection phase, corresponding to steps 706 and 710 in the method of Figure 7. In step 820, the optimal number of clusters is calculated, by executing clustering on the set of coefficients with ever increasing number of number of groups and calculating one or more KPIs, that measure the "quality" of clustering. One measure for the quality of clustering is the average Silhouette. At step 822 a final clustering is then applied to the set of coefficients based upon the chosen automated clustering method and/or user input 824. Additional constraints can also be applied automatically, for example to limit metrology load by limiting the number of clusters, and to avoid occurrence of single wafer groups.

Advice and/or user input can also be used to select between different clustering methods applied in steps 820 and 822. An example of a clustering method is "k-means", disclosed by S P Lloyd in "Least squares quantization in PCM" (PDF). IEEE Transactions on Information Theory 28 (2): 129-137, 1982. Other clustering methods are available. Since process corrections are typically applied and wafers selected per chuck, the clustering applied might have to take this into account. Context data may be used to refine the clustering, as described above with reference to Figure 4.

In the next step 826, the most representative wafers for each cluster and chuck are selected. In the statistical analysis based on object data, each wafer has a position in the multi-dimensional space defined by statistical analysis (for example PCA or other multivariate analysis technique). The most representative wafers can then be selected based on their position within their cluster, in that multi-dimensional space. As described already above with respect to step 710 in Figure 7, one way to achieve this is by calculating a Silhouette value per wafer, and subsequently selecting the wafers with the highest Silhouette value. Additional constraints might be applied, also as described above with reference to step 710.

In another step 828, excursion wafers are detected based on criteria such as for example a low Silhouette value. Other input, and instructions as to the method for excursion wafer detection, are input at step 830. The identity of any excursion wafer is used in a manufacturing execution system 832, so that excursion wafers can be subjected to further investigation, or to rework, or simply to be excluded from further processing. In the context of the present disclosure, the identity of excursion wafers is also used in step 826 as a constraint, to prevent excursion wafers being selected as sample wafers for metrology.

In step 834, measurements of the selected sample wafers are received and processed in whatever manner is appropriate. Corrections are then calculated in step 836, for use in controlling future processing of wafers in the same cluster (or a corresponding future cluster being part of the same thread). Optionally, the selected sample wafers will be processed as send-ahead wafers and measured, before the remainder of the lot is processed. Correction sets can be calculated from measurements on the send ahead wafers and applied in control for the current lot.

The metrology wafer selection mechanism can be refined in a run-to-run control system, as mentioned above. In this scenario, the steps are carried out in an automated fashion and the calculated KPIs, groupings and wafer selection are communicated to a manufacturing execution system in order to trigger further actions. Metrology load due to the need for more wafers can subsequently be balanced with performance improvement, for example by use of sampling scheme optimization, also mentioned above. Threshold setting for proper excursion detection based on the selected KPIs can be done for example by optimizing the area under the receiver-operating curve (ROC) in a manner well-known in itself. The correctness of labeling excursion wafers can be confirmed by subsequent overlay measurements, or labeling by an expert operator, for example in a set-up phase.

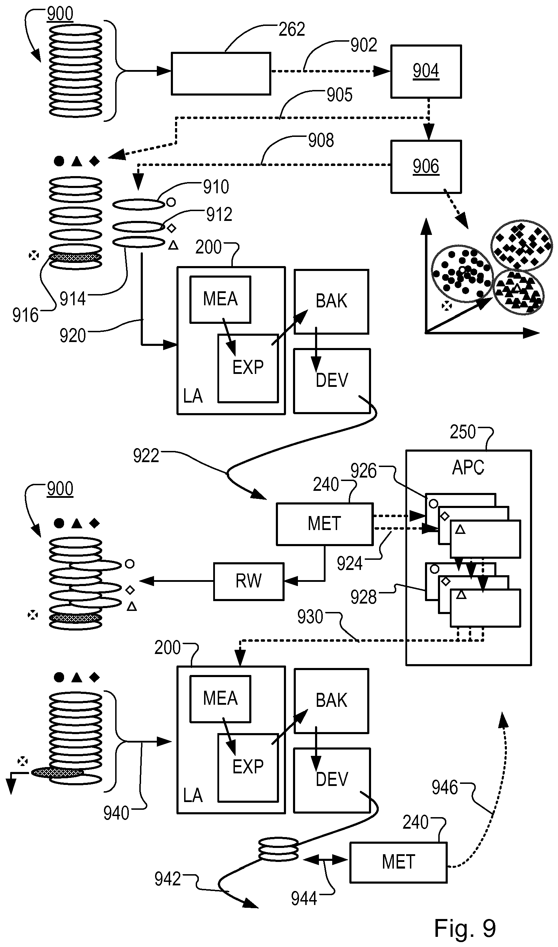

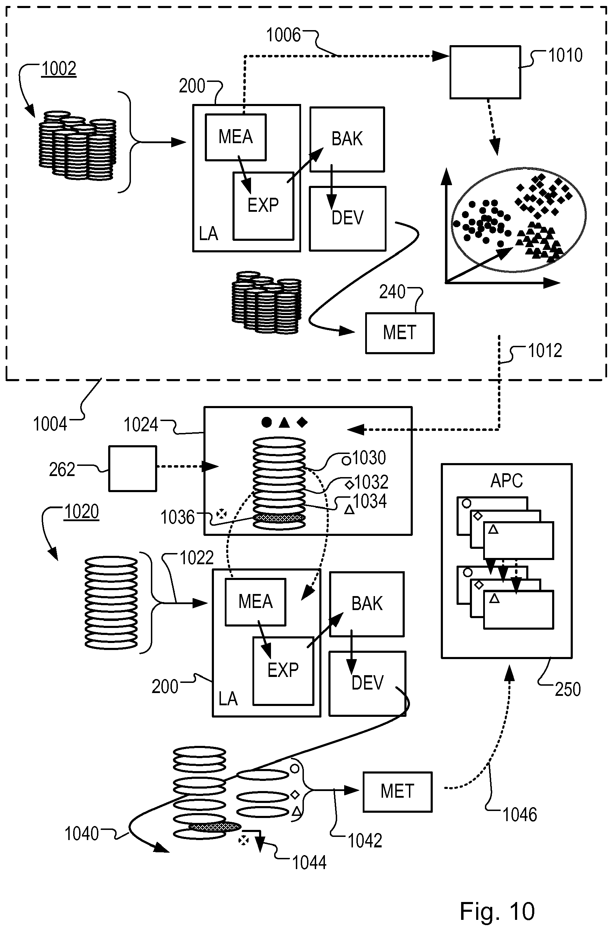

Figures 9 and 10 present schematically the flow of product units (wafers) and information processing, in two different application examples. In the example of Figure 9, object data of a current lot of wafers is used to partition the lot and to select sample wafers for send-ahead processing and metrology. In the example of Figure 10, pre-calculated fingerprints are used to partition a current lot, and sample wafers are selected for metrology after the lot has been processed. Both examples apply the principles of described above with reference to Figures 7 and 8, and the main features of the examples will be described only. It is assumed that the wafers are being processed in the manufacturing facility described above with reference to Figure 2. For simplicity, ancillary steps and equipment such as coating apparatus 208, and the other etching and processing steps are omitted, but will be understood to be an implicit part of the manufacturing process.

In Figure 9, a lot 900 of wafers is processed. As a preliminary step, all of the wafers are measured using the wafer shape metrology apparatus 262. Wafer shape data 804 is delivered to a processor that is configured to perform the calculations of the method of Figures 7 and 8. At 904 the data is processed to identify fingerprints and to partition the wafers into clusters, in the manner described above. At 905, each wafer in the lot is labeled to identify its cluster. For example, the wafers in different clusters may be different layers of different products, or they may be subsets of wafers having the same product layer, but different processing histories. At 906, the object data and the cluster information is used to select one or more sample wafers to be representative of each cluster.

Information 908 identifying the sample wafers is passed to control system of the lithographic apparatus. The clusters of Figure 4 are illustrated as an example. The sample wafers 910, 912, 914 are labeled with the open circle, diamond and triangle symbols, as before. One or more excursion wafers 914 may also be labelled. At 920, the selected sample wafers are processed as send-ahead wafers in the lithographic apparatus 200. Each is processed with regard to its particular cluster and context data.

At 924 the processed send-ahead wafers are sent for measurement of performance parameters (e.g. overlay) in the metrology apparatus 240. The measured performance parameters 924 are delivered to the advanced process control system for use at 926 in calculating process fingerprints for each cluster. From these fingerprints (as well as historic performance data and control parameters), corrections per cluster are calculated at 928 and delivered back to the lithographic apparatus at 930.

In the meantime, the send-ahead wafers 910, 912, 914 are sent for rework and returned to the lot 900. The entire lot (except possibly excursion wafer 916) is then sent at 940 to be processed in the lithographic apparatus 200. This is done using the corrections 930 appropriate to each wafer, according to its cluster, context data and so forth. As mentioned above, calculations and corrections may be performed per chuck, in a twin-stage apparatus. This is implicit in the illustrated examples, and only a single calculation will be shown for simplicity.

After processing, the wafers are forwarded at 942 for subsequent physical and chemical processing steps. Optionally at 944 some or all of them are also sent for metrology in the metrology apparatus 240. Metrology results 946 can be fed back to the advanced process control system 250 where they are used to improve performance in processing subsequent lots.

In the example of Figure 10, reference fingerprints (e.g. PCA components) are calculated in advance, based on historic object data from a large number of historic wafers 1002. A dashed box 1004 surrounds the historic processing part of the method. The object data may be for example alignment data 1006 measured in the lithographic apparatus 200, but this is only one of many possible kinds of object data. Wafer geometry data may be included, for example, and/or performance data measured after a previous process step. At 1010 reference fingerprints such as PC1, PC2, PC3 are then defined by statistical analysis of the object data, supplemented if desired by performance data and/or context data. The reference fingerprints and other results of the statistical analysis are then output at 1012. The other results may for example include criteria for excursion detection.

With regard to a current lot 1020, these are loaded to the lithographic apparatus at 1022. As part of the patterning process, alignment data and other object data is gathered. Object data can alternatively or in addition include measurements of wafer geometry from wafer shape metrology apparatus 262, where used. Stored object data such as alignment data from processing previous layers on the same wafers can also be used as object data. Statistical analysis is performed at 1024 to place the wafers in their clusters, based on the reference fingerprints and associated data 1012, and optionally context data.

During the course of processing the wafers of the lot, or subsequently, statistical analysis can also identify the sample wafers 1030, 1032, 1034 that are most representative of their clusters. Optionally excursion wafers 1036 can be identified. In this example, the representative sample wafers are not processed and measured ahead of the remaining wafers, but are processed along with the other wafers, and labeled for future measurement. After processing the lot 1020, the wafers are sent for further chemical and/or physical processing at 1040. Before and/or after that processing, the sample wafers 1030, 1032 and 1034 are sent at 1042 to metrology apparatus 240 for measurement of performance parameters. The results of measurement are fed at 1046 into the advanced process control system 250 for improving processing of subsequent lots.

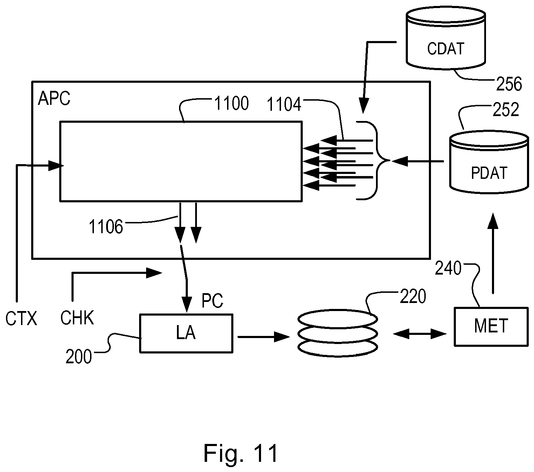

Figure 11 illustrates schematically the operation of another example of a control method implementing the principles of the present disclosure. As can be seen, the general form of the feedback control method is in one sense a hybrid of the methods shown in Figures 3 (a) and (b). In this example, context data relating to the historic wafers and context data CTX relating to the current wafer is used to provide a more selective generation and use of the performance data PDAT. In other examples, object data measured on the current wafers and/or historic wafers can be used to assign wafers to different groups or clusters, as descried above with reference to Figures 5 to 10.

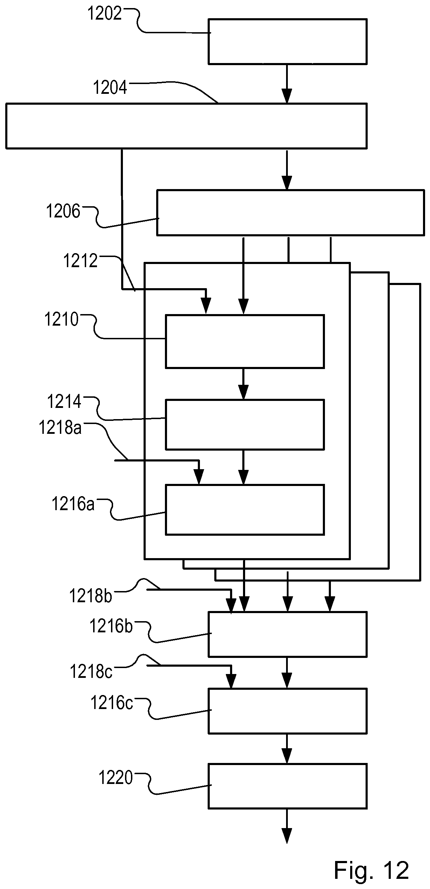

In this example context data CDAT from storage 256 or object data is used to assign the performance data PDAT for each historic lot to one of several threads 1104. These threads are processed effectively in parallel feedback loops by feedback controller 1100, but the process corrections 1106 are generated for the whole lot, not for the wafers of each thread. In the example illustrated, applied in a dual stage lithographic apparatus, corrections are still generated separately for wafers to be processed on different chucks WTa/WTb. So, when new lots are received for processing, only their assigned chuck label CHK is used to select which correction to apply for the current wafer. As will now be described with reference to Figure 12, however, the calculation of the corrections is still based on selecting one or more of the product units as sample product units on a group-by-group basis. Feedback controller receives context data CTX for the individual wafers, for use in calculating the optimum corrections 1106 for the lot as a whole.

Figure 12 is a flowchart, similar to that of Figure 7, expanded and modified to show the difference in processing within the method of Figure 11. Steps numbered 1202 to 1220 correspond to the steps 702-720 of Figure 7, with steps 1216 and 1218 being expanded into separate sub-steps 1216a-1216c and 1218a-1218c, as explained below.

At step 1202, a set of product units, for example semiconductor wafers, are received for processing by an industrial process. At 1204, object data is measured on or in relation to the set of product units (or received from a pre-existing measurement). This object data may be any of the kinds of object data referred to in the background discussion and examples above.

At step 1206, in this example, the set of product units being subjected to the industrial process is partitioned into a plurality of subsets. This partitioning may be performed based on context data received with the product units. Alternatively or in addition, the partitioning may be based on statistical analysis of one or more kinds of object data measured in step 1204, using the methods described above with reference to Figures 4 to 8.

Then, for each subset, at 1210 one or more sample product units is selected for metrology. This step is performed using object data 1212 representing one or more parameters measured in relation to the plurality of product units. The selection of sample product units is based at least partly on statistical analysis of the object data 1212. The object data 1212 used for this step may be the same kind or a different kind than the object data (if any) used in the partitioning step 1206.

At 1214, one or more metrology steps are performed only on the selected sample product units out of the plurality of product units. At 1216a, based at least partly on the metrology of the selected sample product units, estimations of error fingerprints are derived for the subset. The estimations may be derived using context data 1218a, in addition.

At 1216b, the estimations calculated for the different groups are combined into a weighted average estimation. The weightings given to the different groups may be based simply on the number of product units of each group. For example, if one estimation is representative of a group of fifteen product units and another estimation represents only five, the first estimation will be given three times the weight in the weighted average estimation. Other context data 1218b may be used to influence the weightings. For example some wafers may have tighter performance requirements than others, and their estimations can be given increased weight.

At 1216c, corrections for the whole set of product units are calculated based on the weighted average estimation obtained in step 1216b. Additional context data 1218c may be used to influence the corrections. The corrections are used at 1220 to control the processing of the product units, for example to apply patterns to wafers in a semiconductor manufacturing facility.

Summarizing the example of Figures 11 and 12, it will be seen that the selection of sample product units is based at least partly on statistical analysis of the object data, within each subset (group or cluster). Corrections for the whole set of product units are then based on the metrology of the selected sample product units for the different subsets, combined in a weighted average giving different weights to different subsets. By contrast, in the examples of Figures 7 to 10, different corrections are defined for use in controlling processing of the different subsets of the set of product units.

In conclusion, the monitoring and control methods and systems described above can bring a range of benefits, depending on their implementation. -selecting the most representative wafers based on wafer grouping. The disclosure illustrates the use of statistical analysis to obtain values that can be used as key performance indicators (KPIs) for wafer grouping and wafer selection. In other manufacturing environments, product units other than semiconductor substrates can be processed using similar principles.

Embodiments disclosed above enable automated deployment by computing group-based intra-lot corrections. They may be deployed for example in a run-to-run controller, which can, either automatically or with user guidance, refine the grouping and selection criteria, as well as other aspects of the control system, during development and high volume manufacturing. Embodiments of the present disclosure can communicate automatically with the various processing tools, metrology tools, and a manufacturing execution system (MES) of the operator of the manufacturing facility.

Embodiments of the present disclosure offer more stable control by selecting "best wafers", and/or by avoiding excursion wafers "contaminating" feedforward and/or feedback control loops. These loops will be designed to optimize one or more parameters of interest. In the above examples, overlay is used as an example of an important performance parameter. Other parameters such as CD and CD uniformity may also be controlled, by modified choices of object data and performance data, as will be understood by the person skilled in the art.

Grouping and metrology selection based on statistical analysis of object data enables wafer level control based on overlay feedback, without unduly increasing metrology overhead. Even in environments where wafer level control is not possible or not desired, the present disclosure allows improved sampling and calculation of better compromise corrections for the lot as a whole. The same statistical analyses can enable monitoring functions. Quantification of the overlay error distribution can be used for monitoring, and triggering of follow-up actions in order to reduce wafer-to-wafer variation.

The techniques disclosed herein may allow reduction in cycle time, including metrology time compared to known dynamic or distributed sampling methods. This benefit comes from the fact that fewer sample wafers need to be measured, if they are selected to be more reliably representative of the set (or subset) of wafers as a whole. If combined with sampling optimization, dynamic sampling and distributed sampling, the possible gains can be combined.

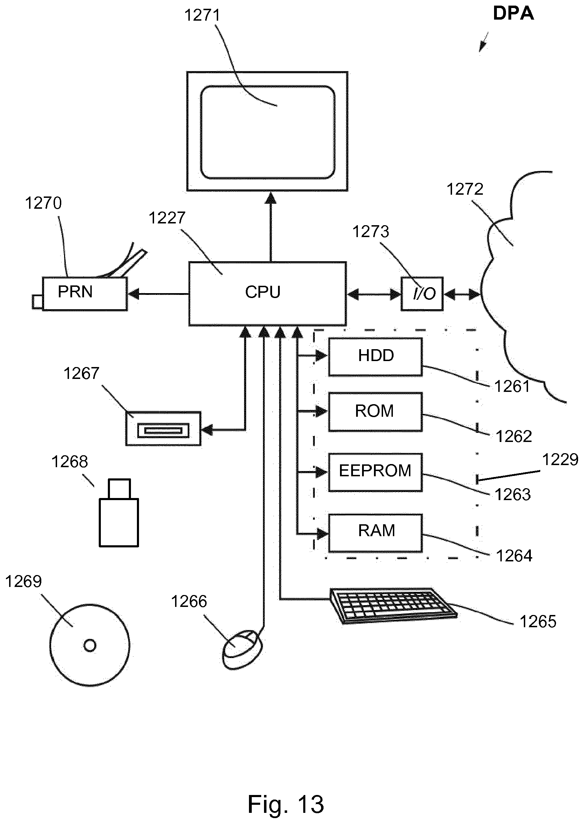

The steps of the methods described above can be automated within any general purpose data processing hardware (computer), so long as it has access to the performance data and context data. The apparatus may be integrated with existing processors such as the lithography apparatus control unit LACU shown in Figure 1 or an overall process control system. The hardware can be remote from the processing apparatus, even being located in a different country. Components of a suitable data processing apparatus (DPA) are shown in Figure 13. The apparatus may be arranged for loading a computer program product comprising computer executable code. This may enable the computer assembly, when the computer program product is downloaded, to implement the functions of the feedback control system as described above.

Memory 1229 connected to processor 1227 may comprise a number of memory components like a hard disk 1261, Read Only Memory (ROM) 1262, Electrically Erasable Programmable Read Only Memory (EEPROM) 1263 and Random Access Memory (RAM) 1264. Not all aforementioned memory components need to be present. Furthermore, it is not essential that aforementioned memory components are physically in close proximity to the processor 1227 or to each other. They may be located at a distance away

The processor 1227 may also be connected to some kind of user interface, for instance a keyboard 1265 or a mouse 1266. A touch screen, track ball, speech converter or other interfaces that are known to persons skilled in the art may also be used.

The processor 1227 may be connected to a reading unit 1267, which is arranged to read data, e.g. in the form of computer executable code, from and under some circumstances store data on a data carrier, like a solid state memory 1268 or a CDROM 1269. The processor 1227 may also be connected to a printer 1270 to print out output data on paper as well as to a display 1271.

The processor 1227 may be connected to a communications network 1272, for instance a public switched telephone network (PSTN), a local area network (LAN), a wide area network (WAN) etc. by means of transmitters/receivers 1273 responsible for input/output (I/O). The processor 1227 may be arranged to communicate with other communication systems via the communications network 1272. In an embodiment of the invention external computers (not shown), for instance personal computers of operators, can log into the processor 1227 via the communications network 1272.

The processor 1227 may be implemented as an independent system or as a number of processing units that operate in parallel, wherein each processing unit is arranged to execute sub-tasks of a larger program. The processing units may also be divided in one or more main processing units with several sub-processing units. Some processing units of the processor 1227 may even be located a distance away of the other processing units and communicate via communications network 1272. Connections between modules can be made wired or wireless.

The computer system can be any signal processing system with analogue and/or digital and/or software technology arranged to perform the functions discussed here.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. As in the example of lithography. The set of measurements that is subjected to statistical analysis can be measurements made for different product units, and/or different instances of measuring the same product units. Although specific reference may have been made above to the use of embodiments of the invention in the context of optical lithography, it will be appreciated that the invention may be used in other types of lithography, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

As already mentioned, the invention may be applied in industrial processing applications quite separate from lithography. It will be understood that grouping can be applied in a variety of "high-mix" manufacturing applications, where different product units are subject to generally similar processing, but with differences in the individual units and/or their handling. Examples might be in production of optical components, automotive manufacture, and any number of other volume manufacturing situations.

The descriptions above are intended to be illustrative, not limiting. Thus, it will be apparent to one skilled in the art that modifications may be made to the invention as described without departing from the spirit and scope of the claims set out below. In addition, it should be appreciated that structural features or method steps shown or described in any one embodiment herein can be used in other embodiments as well.

## Claims

1. A method of controlling an industrial process performed on a plurality of product units, the method comprising:
(a) selecting one or more of the product units as sample product units;
(b) performing one or more metrology steps only on the selected sample product units out of the plurality of product units; and
(c) based at least partly on metrology results of the selected sample product units obtained in step (b), defining corrections for use in controlling processing of the plurality of product units and/or similar product units,
wherein the method further comprises receiving object data representing one or more parameters measured in relation to the plurality of product units and wherein in step (a) the selection of sample product units is based at least partly on statistical analysis of the object data.

2. A method as claimed in claim 1 wherein in step (a), selecting the sample product unit or product units includes elimination of product units that are identified by said statistical analysis as unrepresentative of the plurality of product units.

3. A method as claimed in claim 1 or 2 wherein in step (a), selecting of sample product unit or product units includes preferentially selecting product units that are identified by said statistical analysis as most representative of the plurality of product units.

4. A method as claimed in claim 3 wherein said statistical analysis includes calculating a performance indicator value for a plurality of candidate product units, and identifying the most representative product units by reference to said performance indicator.

5. A method as claimed in claim 4 wherein said performance indicator is a Rousseeuw "silhouette" value.

6. A method as claimed in any preceding claim wherein the statistical analysis of the object data is based on positions of the product units in a multi-dimensional space.

7. A method as claimed in claim 6 wherein said multi-dimensional space is defined at least partly by multivariate analysis of the object data for the plurality of product units.

8. A method as claimed in claim 6 or 7 wherein said multi-dimensional space is defined at least partly by multivariate analysis of object data for product units processed previously.

9. A method as claimed in any preceding claim, wherein the plurality of product units is one subset of a set of product units being subjected to said industrial process, the method comprising as a preliminary step partitioning the set of product units into a plurality of subsets, the steps (a) and (b) of the method being performed separately for each subset.

10. A method as claimed in claim 9 wherein in step (c) different corrections are defined for use in controlling processing of the different subsets of the set of product units, the different corrections being based on the metrology results of the selected sample product units for the corresponding subset.

11. A method as claimed in claim 9 wherein in step (c) corrections are defined for use in controlling processing of the set of product units, the corrections being based on the metrology of the selected sample product units for the different subsets, combined in a weighted average giving different weights to different subsets.

12. A method as claimed in claim 9, 10 or 11 wherein the partitioning of the set of product units into subsets is based at least in part on statistical analysis of the same object data used for selecting the sample product units.

13. A method as claimed in any of claims 9 to 12 wherein the partitioning of the set of product units into subsets is based at least in part on statistical analysis of object data different to the object data used for selecting the sample product units.

14. A method as claimed in any of claims 9 to 13 wherein the partitioning of the set of product units into subsets is performed using k-means.

15. A method as claimed in any of claims 9 to 14 wherein the partitioning step includes selecting a partitioning method from among a number of available partitioning methods.

16. A method as claimed in any of claims 9 to 15 wherein the number of subsets obtained by said partitioning is determined automatically by statistical analysis.

17. A method as claimed in claim 16 wherein the number of subsets is optimized using Rousseeuw silhouettes.

18. A method as claimed in any of claims 9 to 17 wherein the partitioning of the set of product units into subsets is based at least in part on context data representing a processing history of each product unit.

19. A method as claimed in any preceding claim wherein the metrology steps performed on a selected sample product unit in step (b) include sending the sample product unit ahead through said industrial process and measuring performance of the industrial process on the sample product unit, in order to define said corrections for processing of a remainder of the plurality of product units.

20. A method as claimed in claim 19 wherein the sample product unit is reworked and subjected to the industrial process again, but using the defined corrections.

21. A method as claimed in any preceding claim wherein said industrial process comprises a sequence of one or more patterning process steps performed on product units in the form of substrates, each patterning process step comprising one or more patterning operations followed by one or more physical and/or chemical processing operations.

22. A method as claimed in claim 21 wherein said patterning process is performed in a lithographic apparatus and wherein said object data includes wafer shape data measured on the substrates prior to loading into the lithographic apparatus.

23. A method as claimed in claim 21 or 22 wherein said patterning process is performed in a lithographic apparatus and wherein said object data includes alignment data measured on the substrates after loading into the lithographic apparatus.

24. A control apparatus for an industrial process performed on a series of product units, the control apparatus comprising:
an arrangement for selecting one or more of the product units as sample product units for metrology; and
an arrangement for using metrology results of the selected sample product units to define corrections for use in controlling processing of the plurality of product units and/or similar product units,
wherein the selecting arrangement is arranged to for receiving object data representing one or more parameters measured in relation to the plurality of product units and to select the sample product units is based at least partly on statistical analysis of the object data.

25. A control apparatus as claimed in claim 24 wherein the selecting of sample product unit or product units includes elimination of product units that are identified by said statistical analysis as unrepresentative of the plurality of product units.

26. A control apparatus as claimed in claim 24 or 25 wherein the selecting of sample product unit or product units includes preferentially selecting product units that are identified by said statistical analysis as most representative of the plurality of product units.

27. A control apparatus as claimed in claim 26 wherein said statistical analysis includes calculating a performance indicator value for a plurality of candidate product units, and identifying the most representative product units by reference to said performance indicator.

28. A control apparatus as claimed in claim 27 wherein said performance indicator is a Rousseeuw "silhouette" value.

29. A control apparatus as claimed in any of claims 24 to 28 wherein the statistical analysis of the object data is based on positions of the product units in a multi-dimensional space.

30. A control apparatus as claimed in claim 29 wherein said multi-dimensional space is defined at least partly by multivariate analysis of the object data for the plurality of product units.

31. A control apparatus as claimed in claim 29 or 30 wherein said multi-dimensional space is defined at least partly by multivariate analysis of object data for product units processed previously.

32. A control apparatus as claimed in any of claims 24 to 31, wherein the plurality of product units is one subset of a set of product units being subjected to said industrial process, the control apparatus further comprising an arrangement for partitioning the set of product units into a plurality of subsets, the selecting arrangement being arranged to select sample product units separately for each subset.

33. A control apparatus as claimed in claim 32 wherein the arrangement for defining corrections is operable to define different corrections for use in controlling processing of the different subsets of the set of product units, the different corrections being based on the metrology results of the selected sample product units for the corresponding subset.

34. A control apparatus as claimed in claim 32 wherein the arrangement for defining corrections is operable to define corrections for use in controlling processing of the set of product units, the corrections being based on the metrology of the selected sample product units for the different subsets, combined in a weighted average giving different weights to different subsets.

35. A control apparatus as claimed in claim 32, 33 or 34 wherein the partitioning of the set of product units into subsets is based at least in part on statistical analysis of the same object data used for selecting the sample product units.

36. A control apparatus as claimed in any of claims 32 to 35 wherein the partitioning of the set of product units into subsets is based at least in part on statistical analysis of object data different to the object data used for selecting the sample product units.

37. A control apparatus as claimed in any of claims 32 to 36 wherein the partitioning of the set of product units into subsets is performed using k-means.

38. A control apparatus as claimed in any of claims 32 to 37 wherein the partitioning arrangement is operable to implement a partitioning method selected from among a number of available partitioning methods.

39. A control apparatus as claimed in any of claims 32 to 38 wherein the partitioning arrangement is operable to determine the number of subsets obtained by said partitioning automatically by statistical analysis.

40. A control apparatus as claimed in claim 39 wherein the number of subsets is optimized using Rousseeuw silhouettes.

41. A control apparatus as claimed in any of claims 24 to 40 wherein the partitioning of the set of product units into subsets is based at least in part on context data representing a processing history of each product unit.

42. A control apparatus as claimed in any of claims 24 to 41 wherein the arrangement for defining corrections is arranged to define corrections for a patterning process step performed on product units in the form of substrates.

43. A control apparatus as claimed in claim 42 wherein said patterning process step is performed in a lithographic apparatus and wherein the selecting arrangement is arranged to use object data that includes wafer shape data measured on the substrates prior to loading into the lithographic apparatus.

44. A control apparatus as claimed in claim 42 or 43 wherein said patterning process is performed in a lithographic apparatus and wherein the selecting arrangement is arranged to use object data that includes alignment data measured on the substrates after loading into the lithographic apparatus.

45. A computer program product comprising machine readable instructions for causing a general purpose data processing apparatus to perform the steps (a) and (c) of a method as claimed in any of claims 1 to 23

46. A computer program product comprising machine readable instructions for causing a general purpose data processing apparatus to implement the selecting arrangement and the arrangement for defining corrections of a control apparatus as claimed in any of claims 24 to 44.

47. A lithographic system including a control apparatus as claimed in any of claims 24 to 44.
